# EUROPÄISCHE PATENTANMELDUNG

(11) **EP 4 648 090 A1**
(43) Veröffentlichungstag der Anmeldung: **12.11.2025**
(21) Anmeldenummer: 24175153.6
(22) Anmeldetag: 10.05.2024
(51) Int. Cl.: H01L 21/66, C30B 29/06

(54) **VERFAHREN ZUR BESTIMMUNG VON KRISTALLDEFEKTEN IN EINEM WERKSTÜCK AUS EINKRISTALLINEM SILIZIUM**

(71) Anmelder: Siltronic AG, 81677 München (DE)
(72) Erfinder: EHLERT, Andreas, 84547 Emmerting (DE); KNIPPERTZ, Johannes, 84489 Burghausen (DE); KOMODA, Mitsunori, 84489 Burghausen (DE)
(74) Vertreter: Hasenhütl, Eva

(57) **Zusammenfassung**

Verfahren zur Bestimmung von Kristalldefekten in einem Werkstück aus einkristallinem Silizium, umfassend die folgenden Schritte
**(i)** Reaktives lonenätzen mindestens einer Oberfläche des Werkstücks in einem Gasgemisch umfassend Sauerstoff und eine oder mehrere halogenhaltige Verbindungen ausgewählt aus der Gruppe bestehend aus elementaren Halogen X₂, Halogenwasserstoff HX und Stickstoffhalogenid NHₙX₃₋ₙ, wobei
X ausgewählt ist aus der Gruppe von Cl und Br, und 0 ≤ n ≤ 2,
die Flussrate von Sauerstoff und von jeder der ein oder mehreren halogenhaltigen Verbindung jeweils nicht weniger als 5 sccm und nicht mehr als 100 sccm beträgt, und
die mindestens eine, zu ätzende Oberfläche des Werkstücks dem Gasgemisch für nicht weniger als 10 Sekunden und nicht mehr als 20 Minuten ausgesetzt wird; und

**(ii)** Identifizieren von Defekten auf der geätzten Oberfläche des Werkstücks mittels Lichtstreumessung.

## Beschreibung

### Technisches Gebiet

Die vorliegende Erfindung betrifft ein Verfahren zur Bestimmung von Kristalldefekten in einem Werkstück aus einkristallinem Silizium und ein Verfahren zur Herstellung von Scheiben aus einkristallinem Silizium.

### Stand der Technik

Scheiben aus monokristallinem (einkristallinem) Silizium (Siliziumwafer) werden in einer Vielzahl von Prozessschritten hergestellt, die unter anderem das Ziehen eines Einkristallstabs aus einer Schmelze, das Zersägen des Kristalls in Scheiben, das Schleifen und/oder Läppen, das Kantenverrunden, das chemische Ätzen, das Polieren und das chemische Reinigen der Scheiben umfassen. Während der Herstellung von Bauelementen auf besagten Halbleiterscheiben werden thermische Prozesse und komplexe Beschichtungsschritte durchgeführt, die eine hohe Reinheit der Oberfläche und insbesondere die weitgehende Abwesenheit von Kristalldefekten und Fremdmaterial an der Oberfläche erfordern. Um diese Anforderungen sicherstellen zu können, sind Verfahren erforderlich, die es ermöglichen, Defekte mit einer Größe von wenigen Nanometern zu identifizieren.

Konventionelle Methoden der Oberflächenanalytik wie die Transmissionselektronenmikroskopie (TEM) sind in der Probenvorbereitung und der Messung aufwendig und außerdem auf kleine Flächen begrenzt, so dass solche Methoden ungeeignet sind, um die gesamte Oberfläche einer größeren Fläche eines Werkstücks aus einkristallinem Silizium, beispielsweise der gesamten Vorderseite einer Scheibe aus einkristallinem Silizium, zu untersuchen.

Durch reaktives Ionenätzen (Reactive Ion Etching, RIE) wird defektfreies einkristallines Material an der Oberfläche eines Werkstücks aus einkristallinem Silizium entfernt, während Defekte, beispielsweise Oxide, als Ätzrückstände in Form von Erhöhungen an der Oberfläche zurückbleiben. Im Stand der Technik wir dafür beispielsweise ein Gasgemisch aus HBr, NF₃, O₂, und Helium verwendet (siehe K. Nakashima et al. Journal of The Electrochemical Society, 147 (11) 4294-4296 (2000) und K. Nakashima et al. Journal of The Electrochemical Society, 152 (5) G339-G344 (2005)). Verfahren zum reaktiven Ionenätzen sind weiterhin in den Druckschriften JP 2007-123542 A, JP 2000-58509A, JP4121643 und JP4888632B2 beschrieben.

Die Erhöhungen können mit einem Lichtmikroskop oder einem Rasterelektronenmikroskop erfasst werden. Ihre Anzahl kann von einem Datenprozessor oder einem Partikelzähler gemessen werden. Die im Stand der Technik beschriebenen Verfahren erfordern jedoch meist eine thermische Behandlung vor und/oder eine chemische Behandlung nach dem eigentlichen RIE-Verfahren. Solche zusätzlichen Behandlungen können die Morphologie und Form der Defekte verändern. Außerdem ist das RIE-Verfahren im Stand der Technik so ausgestaltet, dass ein relativ starker Materialabtrag stattfindet. Sowohl die zusätzlichen Behandlungsschritte als auch die relativ harschen Bedingungen des RIE-Verfahrens selbst führen zu einer starken Veränderung der Morphologe und Geometrie der Oberfläche des zu untersuchenden Werkstückes, was die Identifizierung der Ursachen der Defekte erschwert.

Außerdem führen die im Stand der Technik beschriebenen Verfahren zu einer verhältnismäßig hohen Rauigkeit der Oberfläche, was die Empfindlichkeit von optischen Messmethode, beispielsweise auf Lichtstreuung basierenden Messmethoden, stark verringert.

### Technische Aufgabe der Erfindung und deren Lösung

Aufgabe der vorliegenden Erfindung ist die Bereitstellung eines schonenderen Verfahrens zur Identifizierung von Kristalldefekten auf oder nahe der Oberfläche eines Werkstücks aus einkristallinem Silizium, welches eine hohe Empfindlichkeit aufweist und es ermöglicht, die Positionen und Größen der identifizierten Defekte zuverlässig zu bestimmen. Die Veränderung der Defekte bezüglich Ihrer Form und Morphologie soll möglichst geringgehalten werden. Zudem soll das Verfahren für die Prozesskontrolle geeignet sein.

Gelöst wird die Aufgabe durch ein Verfahren zur Bestimmung von Kristalldefekten in einem Werkstück aus einkristallinem Silizium gemäß dem ersten Aspekt der vorliegenden Erfindung. Das Verfahren umfasst die folgenden Schritte:
**(i)** Reaktives Ionenätzen mindestens einer Oberfläche des Werkstücks in einem Gasgemisch umfassend Sauerstoff und eine oder mehrere halogenhaltige Verbindungen ausgewählt aus der Gruppe bestehend aus elementaren Halogen X₂, Halogenwasserstoff HX und Stickstoffhalogenid NHₙX₃₋ₙ, wobei
   X ausgewählt ist aus der Gruppe von Cl und Br, und 0 ≤ n ≤ 2,
   die Flussrate von Sauerstoff und von jeder der ein oder mehreren halogenhaltigen Verbindung jeweils nicht weniger als 5 sccm und nicht mehr als 100 sccm beträgt (sccm - Standardkubikzentimeter pro Minute), und
   die mindestens eine, zu ätzende Oberfläche des Werkstücks dem Gasgemisch für nicht weniger als 10 Sekunden und nicht mehr als 20 Minuten ausgesetzt wird; und
**(ii)** Identifizierung von Defekten auf der geätzten Oberfläche des Werkstücks mittels Lichtstreumessung.

Es wurde überraschend festgestellt, dass durch das erfindungsgemäße Verfahren einerseits Defekte in Form von Erhebungen an der geätzten Oberfläche kenntlich gemacht werden können, diese aber andererseits in Ihrer Geometrie und Morphologie weniger stark verändert werden als in den im Stand der Technik beschriebenen RIE-Verfahren. Das erfindungsgemäße Verfahren ermöglicht eine Identifizierung der Defekte, ohne dass eine thermische Behandlung oder eine zusätzliche chemische Behandlung vor oder nach dem reaktiven Ionenätzen erforderlich ist.

Aufgrund der geringeren Rauheit der Oberfläche nach dem reaktiven Ionenätzen im Vergleich zu den im Stand der Technik beschriebenen Verfahren ist es möglich, die Defekte auf der geätzten Oberfläche des Werkstücks mittels Lichtstreumessung mit hoher Empfindlichkeit zu identifizieren. Somit kann eine relativ große Fläche eines Werkstücks aus einkristallinem Silizium schnell und effizient auf Defekte mit einer Größe im Nanometerbereich untersucht werden. Dadurch eignet sich das erfindungsgemäße Verfahren dafür, im Rahmen der Prozesskontrolle in der Fertigung von Scheiben aus einkristallinem Silizium eingesetzt zu werden.

Da im Verfahren gemäß dem ersten Aspekt der vorliegenden Erfindung Defekte in Ihrer Geometrie und Morphologie weniger stark verändert werden als in den im Stand der Technik beschriebenen RIE-Verfahren, eignet sich das Verfahren gut, um die Ursachen der Defekte zu untersuchen und zu identifizieren.

In einem zweiten Aspekt ist die vorliegende Erfindung auf ein Verfahren zur Herstellung von Scheiben aus einkristallinem Silizium gerichtet, wobei das Verfahren die folgenden Schritte umfasst:
Ziehen eines Einkristallstabs aus einkristallinem Silizium gemäß dem Czochralski-Verfahren;
Schleifen des Einkristallstabs;
Sägen des geschliffenen Einkristallstabs in Scheiben;
Schleifen und/oder Läppen der Scheiben;
chemisches Ätzen der Scheiben;
Polieren der Scheiben; und
chemisches Reinigen der Scheiben,
dadurch gekennzeichnet, dass das Verfahren zur Bestimmung von Kristalldefekten gemäß dem ersten Aspekt der vorliegenden Erfindung stichprobenartig im Rahmen der Prozesskontrolle durchgeführt wird.

Dieses Verfahren ermöglicht es, die Qualität der hergestellten Scheiben aus einkristallinem Silizium in einem industriellen Prozess zu evaluieren und die Ursache von Defekten leichter zu identifizieren.

### Kurzbeschreibung der Figuren

**Fig. 1** zeigt die Positionen der im Schritt (ii) des Ausführungsbeispiels 1 mittels Lichtstreumessung bestimmten Defekte auf einer Scheibe aus einkristallinem Silizium. Die Defekte sind als weiße Punkte gekennzeichnet.
**Fig. 2** zeigt ein im Schritt (iii) des Ausführungsbeispiels 1 mit einem Rasterelektronenmikroskop aufgenommenes Bild einer typischen Erhöhung (Defekt) auf der Oberfläche einer Scheibe aus einkristallinem Silizium.
**Fig. 3a** zeigt eine im Schritt (iii) des Ausführungsbeispiels 2 mit einem Rasterelektronenmikroskop aufgenommene Aufsicht auf eine Erhöhung (Defekt) auf der Oberfläche einer Scheibe aus einkristallinem Silizium. **Fig. 3b** zeigt eine rasterelektronenmikroskopische Aufnahme desselben Defekts wie **Fig. 3a** nach einer Kippung der Probe im Rasterelektronenm ikroskop.
**Fig. 4** zeigt die Positionen der im Schritt (ii) des Ausführungsbeispiels 3 mittels Lichtstreumessung bestimmten Defekte auf einer Scheibe aus einkristallinem Silizium. Die Defekte sind als schwarze und graue Punkte gekennzeichnet.
**Fig. 5a** zeigt ein im Schritt (iii) des Ausführungsbeispiels 3 mit einem Rasterkraftmikroskop aufgenommenes Bild einer Erhöhung (Defekt) auf der Oberfläche einer Scheibe aus einkristallinem Silizium. **Fig. 5b** zeigt das Höhenprofil der in **Fig. 5a** aufgenommenen Erhöhung.
**Fig. 6** zeigt die Positionen der im Schritt (iii) des Ausführungsbeispiels 4 mittels Lichtstreumessung bestimmten Defekte auf einer Scheibe aus einkristallinem Silizium. Die Defekte sind als schwarze und graue Punkte gekennzeichnet.

### Detaillierte Beschreibung der Erfindung

Das Verfahren zur Bestimmung von Kristalldefekten in einem Werkstück aus einkristallinem Silizium gemäß dem ersten Aspekt der vorliegenden Erfindung wird vorzugsweise zur Bestimmung von Kristalldefekten in Scheiben aus einkristallinem Silizium verwendet. Das Werkstück ist also vorzugsweise eine Scheibe aus einkristallinem Silizium. Die Scheibe aus einkristallinem Silizium kann dabei dotiert sein, beispielsweise mit einem oder mehreren Elementen ausgewählt aus der Gruppe von Sauerstoff, Stickstoff, Bor, Phosphor, Arsen und Antimon. Die Scheibe kann einen Durchmesser von 150 mm bis 450 mm haben, besonders bevorzugt einen Durchmesser 200 mm bis 300 mm. Die Dicke der Scheibe beträgt vorzugsweise nicht weniger als 500 µm, besonders bevorzugt nicht weniger als 700 µm, und vorzugsweise nicht mehr als 1000 µm.

Im Schritt (i) des erfindungsgemäßen Verfahrens wird durch reaktives Ionenätzen defektfreies, einkristallines Material an der Oberfläche des Werkstücks aus einkristallinem Silizium so entfernt, dass Defekte, beispielsweise Oxide, als Erhöhungen an der Oberfläche zurückbleiben. Die Erhöhungen können einen nahezu kreisförmigen oder oval Querschnitt haben und verjüngen sich nach oben. So können die Erhöhungen beispielsweise konusförmig sein. Kristalldefekte im Sinne der vorliegenden Erfindung bleiben nach dem reaktiven Ionenätzen als Erhöhungen auf der geätzten Oberfläche des Werkstücks zurück, vorzugsweise als Erhöhungen mit einer Höhe von nicht weniger als 20 nm, mehr bevorzugt nicht weniger als 50 nm, am meisten bevorzugt nicht weniger als 100 nm. Vorzugsweise haben die Erhöhungen ein Höhe von nicht mehr als 1000 nm. Die Begriffe Defekt und Kristalldefekt werden in der vorliegenden Erfindung synonym gebraucht. Kristalldefekte im Sinne der vorliegenden Erfindung sind sowohl Defekte im Kristallgitter des Siliziumeinkristalls als auch Ablagerungen von Fremdmaterial an oder auf der Oberfläche des Siliziumeinkristalls.

Das reaktive Ionenätzen (Reactive Ion Etching, RIE) gemäß dem Schritt (i) des erfindungsgemäßen Verfahrens ist ein ionenunterstützter Reaktivätzprozess. Dabei werden in einem Plasma, vorzugsweise zwischen zwei Elektroden, Gase in freie Elektronen, Ionen und Radikale zersetzt. Das Ätzen der Oberfläche des Werkstücks aus einkristallinem Silizium erfolgt durch Ionen und/oder ladungsneutrale Radikale. Bei reaktivem Ionenätzen wird die chemische Ätzreaktion durch die kinetische Energie der auftreffenden Ionen ausgelöst. Vorzugsweise finde das reaktive Ionenätzen in einer Kammer mit zwei Elektroden und einem Vakuumsystem statt. Mittels des Vakuumsystems können die beim Ätzen entstandenen, flüchtigen Produkte, beispielsweise Silane oder Halogensilane, entfernt werden. Das reaktive Ionenätzen gemäß dem Schritt (i) des erfindungsgemäßen Verfahrens kann beispielsweise in einer kommerziell verfügbaren Vorrichtung für reaktives Ionenätzen des Typs PlasmaPro System 133 RIE des Herstellers Oxford Instruments durchgeführt werden.

In der vorliegenden Erfindung wird das Plasma vorzugsweise durch ein hochfrequentes Magnetfeld erzeugt. Das hochfrequente Magnetfeld hat vorzugsweise eine magnetische Flussdichte von nicht weniger als 0.5 und nicht mehr als 20 mT. Der Druck während des Schrittes des reaktiven Ionenätzens beträgt vorzugsweise nicht weniger als 0,5 und nicht mehr als 20 Pa. Der Druck bezieht sich dabei auf den Druck in der Kammer der Vorrichtung, in der das Plasma erzeugt und mit der Oberfläche des Werkstücks in Kontakt gebracht wird.

Die zu ätzende Oberfläche des Werkstücks ist dabei vorzugsweise die Vorderseite einer Scheibe aus einkristallinem Silizium. Die Vorderseite ist diejenige Seite der Scheibe, auf der später Bauelemente hergestellt werden sollen. Die zu ätzende Oberfläche kann aber auch die Oberfläche an einer Bruchkante eines Werkstückes, beispielsweise einer Scheibe aus einkristallinem Silizium sein.

Das Gasgemisch umfasst Sauerstoff und eine oder mehrere halogenhaltige Verbindungen ausgewählt aus der Gruppe bestehend aus elementaren Halogen X₂, Halogenwasserstoff HX und Stickstoffhalogenid NHₙX₃₋ₙ, wobei X ausgewählt ist aus der Gruppe von Cl und Br, und 0 ≤ n ≤ 2. Vorzugsweise umfasst das Gasgemisch Sauerstoff und eine oder mehrere halogenhaltige Verbindungen ausgewählt aus der Gruppe bestehend aus Chlor, Brom, Chlorwasserstoff und Bromwasserstoff. In einer besonders bevorzugten Ausführungsform umfasst das Gasgemisch Sauerstoff und eine oder mehrere Verbindungen ausgewählt aus der Gruppe bestehend aus Chlor und Bromwasserstoff. Außerdem umfasst das Gasgemisch vorzugsweise mindestens ein Inertgas ausgewählt aus der Gruppe aus Helium, Argon und Stickstoff, mehr bevorzugt Helium und/oder Argon, am meisten bevorzugt Argon. In einer Ausführungsform besteht das Gasgemisch aus (a) Sauerstoff; (b) einer oder mehreren halogenhaltigen Verbindungen ausgewählt aus der Gruppe bestehend aus elementaren Halogen X₂, Halogenwasserstoff HX und Stickstoffhalogenid NHₙX₃₋ₙ, wobei X ausgewählt ist aus der Gruppe von Cl und Br, und 0 ≤ n ≤ 2; und (c) einem Inertgas ausgewählt aus der Gruppe aus Helium, Argon und Stickstoff. Das Gasgemisch umfasst also mehr bevorzugt Sauerstoff und Bromwasserstoff, Sauerstoff und Chlor, oder Sauerstoff, Bromwasserstoff und Chlor. Am meisten bevorzugt besteht das Gasgemisch aus Sauerstoff, Bromwasserstoff und Argon; Sauerstoff, Chlor und Argon; oder Sauerstoff, Bromwasserstoff, Chlor und Argon. In einer besonders bevorzugten Ausführungsform besteht das Gasgemisch aus Sauerstoff, Chlor, Bromwasserstoff und Argon.

Dabei beträgt die Flussrate von Sauerstoff und von jeder der ein oder mehreren halogenhaltigen Verbindungen jeweils nicht weniger als 5 sccm und nicht mehr als 100 sccm, vorzugsweise nicht weniger als 10 sccm und nicht mehr als 50 sccm, am meisten bevorzugt nicht weniger als 20 sccm und nicht mehr als 40 sccm. Die Flussrate von Argon beträgt vorzugsweise nicht weniger als 10 sccm und nicht mehr als 300 sccm, mehr bevorzugt nicht weniger als 20 sccm und nicht mehr als 200 sccm, am meisten bevorzugt nicht weniger als 50 sccm und nicht mehr als 150 sccm. Die Einheit Standardkubikzentimeter pro Minute (sccm) gibt dabei den Volumenstrom unter Normalbedingungen (T=0°C; p=1013 mbar) wieder. Wenn das Gasgemisch aus Sauerstoff, Chlor, Bromwasserstoff und Argon besteht, beträgt die Flussraten von Sauerstoff, Chlor und Bromwasserstoff vorzugsweise jeweils nicht weniger als 10 sccm und nicht mehr als 50 sccm, und die Flussrate von Argon vorzugsweise nicht weniger als 20 sccm und nicht mehr als 200 sccm.

Die mindestens eine, zu ätzende Oberfläche des Werkstücks wird dem Gasgemisch für nicht weniger als 10 Sekunden und nicht mehr als 20 Minuten ausgesetzt, vorzugsweise für nicht weniger als 20 Sekunden und nicht mehr als 10 Minuten, mehr bevorzugt für nicht weniger als 30 Sekunden und nicht mehr als 5 Minuten, und am meisten bevorzugt für nicht weniger als 30 Sekunden und nicht mehr als 2 Minuten. Im Folgenden wird die Zeit, für die Oberfläche des Werkstücks dem Gasgemisch ausgesetzt ist, als Ätzzeit bezeichnet.

Wenn die Oberfläche des Werkstücks dem Gasgemisch für nicht weniger als 10 Sekunden ausgesetzt ist, wird durch das Ätzen der Großteil der Defekte als Erhöhungen auf der geätzten Oberfläche kenntlich gemacht. Beträgt die Ätzzeit nicht weniger als 15 Sekunden, vorzugsweise nicht weniger als 20 Sekunden, mehr bevorzugt nicht weniger als 30 Sekunden, kann die Anzahl der Defekte mit einer Höhe von nicht weniger als 20 nm, vorzugsweise mit einer Höhe von nicht weniger als 50 nm, weiter erhöht werden.

Wenn die Ätzzeit nicht mehr als 20 Minuten beträgt, ist sichergestellt, dass die Oberfläche nicht zu stark aufgeraut wird, so dass eine Lichtstreumessung zur Identifzierung der Größen und Positionen der als Erhöhungen kenntlich gemachten Defekte möglich ist. Durch eine Verringerung der Ätzzeit auf nicht mehr als 10 Minuten, vorzugsweise nicht mehr als 5 Minuten, kann die Aufrauhung der Oberfläche weiter verringert werden, so dass die Empfindlichkeit der Lichtstreumessung weiter erhöht werden kann. Der Schritt (i) erfordert keine nachgeschaltete chemische Behandlung der Oberfläche, beispielsweise mit Flusssäure, so dass die Morphologie und Geometrie der Defekte weniger stark verändert wird.

In einer bevorzugten Ausführungsform der vorliegenden Erfindung wird die Zeit, für die die mindestens eine, zu ätzende Oberfläche des Werkstücks dem Gasgemisch ausgesetzt wird, also die Ätzzeit, so eingestellt, dass das Profil auf der geätzten Oberfläche des Werkstücks eine Tiefe von nicht mehr als 1000 nm, vorzugsweise eine Tiefe von nicht mehr als 500 nm, am meisten bevorzugt eine Tiefe von nicht mehr als 300 nm, aufweist. Dabei entspricht die Tiefe dem arithmetischen Mittelwert der Höhen der gemessenen Erhöhungen, die beispielsweise im Schritt (iii) mittels Elektronenmikroskopie oder Rasterkraftmikroskopie bestimmt werden können, wobei mindestens 20 Erhöhungen, vorzugsweise mindestens 50 Erhöhungen berücksichtigt werden.

In einer Ausführungsform haben, nach dem reaktiven Ionenätzen im Schritt (i), nicht weniger als 80% der im Schritt (ii) identifizierten Defekte eine Höhe von nicht weniger als 20 nm und nicht mehr als 1000 nm. Vorzugsweise haben nicht weniger als 80% der im Schritt (ii) identifizierten Defekte eine Höhe von nicht weniger als 50 nm und nicht mehr als 500 nm. Der Anteil der Defekte, die die geforderte Höhe haben, kann im Schritt (iii) durch Untersuchung von mindestens 20, vorzugsweise mindestens 50, im Schritt (ii) identifizierten Defekte auf der geätzten Oberfläche mittels Elektronenmikroskopie oder Rasterkraftmikroskopie ermittelt werden. Die Höhe eines Defekts entspricht also der lokalen Profiltiefe.

Optional kann das Werkstück vor dem reaktiven Ionenätzen einer thermischen Behandlung unterzogen werden, beispielsweise um thermische Prozessschritte im Herstellungsprozess von elektronischen Bauelementen nachzubilden und die damit einhergehende Ausbildung von Defekten zu untersuchen. Eine thermische Vorbehandlung ist jedoch nicht notwendig.

Im Schritt (ii) erfolgt schließlich das Identifizieren von Defekten auf der geätzten Oberfläche des Werkstücks mittels Lichtstreumessung. Die Lichtstreumessung kann mit einem Gerät der Hersteller KLA Tencor Corp. oder Hitachi High-Tech Corp erfolgen. Die Oberflächeninspektion im Schritt (ii) beruht also auf dem Prinzip der Lichtstreuung, wobei es im Wirkungsquerschnitt eines Defektes zu einem veränderten Streulichtsignal kommt. Die Inspektion von Scheiben aus Halbleitermaterial hinsichtlich Kontamination und Beschädigung mit Hilfe von optischen Verfahren ist beispielsweise in der US RE37,740 E beschrieben, die ein Streulichtinspektionsgerät, mit dem die Oberfläche einer schnell rotierenden Scheibe mit einem Laser abgetastet wird, beschreibt. Solche Streulichtmess-Systeme liefern unter anderem Informationen über die Position der Defekte auf der Scheibenoberfläche sowie deren Größe. Diese Information kann in elektronischer Form gespeichert werden, vorzugsweise in einem standardisierten Dateiformat, so dass diese Information auch für nachfolgende analytische Messungen der Scheibe auf anderen Messgeräten zur Verfügung steht. Ein solches standardisiertes Dateiformat ist KLARF (**KLA R**eview **F**ile **F**ormat), welches Informationen über die Positionen von Defekten auf der Oberfläche eines Werkstückes, vorzugsweise einer Scheibe aus einkristallinem Silizium, und zusätzlich die Position dieser Defekte bezogen auf verschiedene Messgeräte speichert. Im Schritt (ii) des erfindungsgemäßen Verfahrens könne also die mittels Lichtstreumessung ermittelten Positionen und Größen der identifizierten Defekte in einem elektronischen Format gespeichert werden, vorzugsweise im Dateiformat KLRAF. Durch Referenzierung des Lichtstreumess-Systems mittels Kugeln aus Polystyrol-Latex mit bekanntem Durchmesser können die Größen der Defekte im Schritt (ii) bestimmt werden. So können beispielsweise Defekte mit einer Größe von 50 nm bis 60 nm im Schritt (ii) identifiziert werden.

Um Aussagen über die Ursachen der gefundenen Defekte treffen zu können, kann ein zusätzlicher Schritt (iii) durchgeführt werden, in welchem bestimmte, im Schritt (ii) identifizierte Defekte ausgewählt und mittels Elektronenmikroskopie und/oder Rasterkraftmikroskopie untersucht werden. Dafür kann ein Rasterelektronenmikroskop des Typs Auriga des Herstellers Zeiss und/oder ein Rasterkraftmikroskop der Hersteller Park oder Semilab verwendet werden. Vorzugsweise wird im Schritt (iii) die Geometrie und/oder Morphologie der bestimmten, ausgewählten Defekte untersucht. Besonders bevorzugt wird dabei die Geometrie, also die Form der Erhöhungen, untersucht. Es kann aber auch die chemische Zusammensetzung der Defekte analysiert werden, beispielsweise mittels Raster-Elektronenmikroskopie (REM) mit verknüpften Analysatoren wie EDX (energiedispersive Röntgenspektroskopie) oder ein mit einem Raster-Elektronenmikroskopie (REM) gekoppelten SIMS-Gerät (Sekundärionen-Massenspektrometrie). So kann ein Rasterelektronenmikroskop des Typs Auriga 60 des Herstellers Zeiss, das mit einem EDX-Gerät des Typs Octane Elite des Herstellers AMETEK EDAX, und/oder mit einem SIMS-Gerät des TYPS EQS Herstellers Hiden Analytical gekoppelt ist, verwendet werden, um die chemische Zusammensetzung der ausgewählten Defekte zu bestimmen.

In einem zweiten Aspekt ist die vorliegende Erfindung auf ein Verfahren zur Herstellung von Scheiben aus einkristallinem Silizium gerichtet, wobei das Verfahren die folgenden Schritte umfasst:
Ziehen eines Einkristallstabs aus einkristallinem Silizium gemäß dem Czochralski-Verfahren;
Schleifen des Einkristallstabs;
Sägen des geschliffenen Einkristallstabs in Scheiben;
Schleifen und/oder Läppen der Scheiben;
chemisches Ätzen der Scheiben;
Polieren der Scheiben; und
chemisches Reinigen der Scheiben,
dadurch gekennzeichnet, dass das Verfahren gemäß dem ersten Aspekt der vorliegenden Erfindung stichprobenartig im Rahmen der Prozesskontrolle durchgeführt wird.

Dadurch, dass das Verfahren gemäß dem ersten Aspekt der vorliegenden Erfindung stichprobenartig im Rahmen der Prozesskontrolle durchgeführt wird, kann die Qualität der hergestellten Scheiben aus einkristallinem Silizium, insbesondere die Anzahl, Verteilung und Größe von Kristalldefekten, mit hoher Empfindlichkeit evaluiert werden. Außerdem kann durch die Untersuchung der Morphologie und Geometrie, mittels des Schritts (iii) des Verfahrens gemäß dem ersten Aspekt, die Ursache der Defekte leichter identifiziert werden. Dies ermöglicht es, in den Prozess einzugreifen und die Ursache de Defekte zu beseitigen. Dadurch kann eine gleichbleibende, hohe Qualität der Scheiben gewährleistet werden.

### Ausführungsbeispiele

### Ausführungsbeispiel 1

Eine polierte und chemisch gereinigte Scheibe aus einkristallinem Silizium wurde in einer RIE-Anlage des Typs PlasmaPro System 133 RIE des Herstellers Oxford

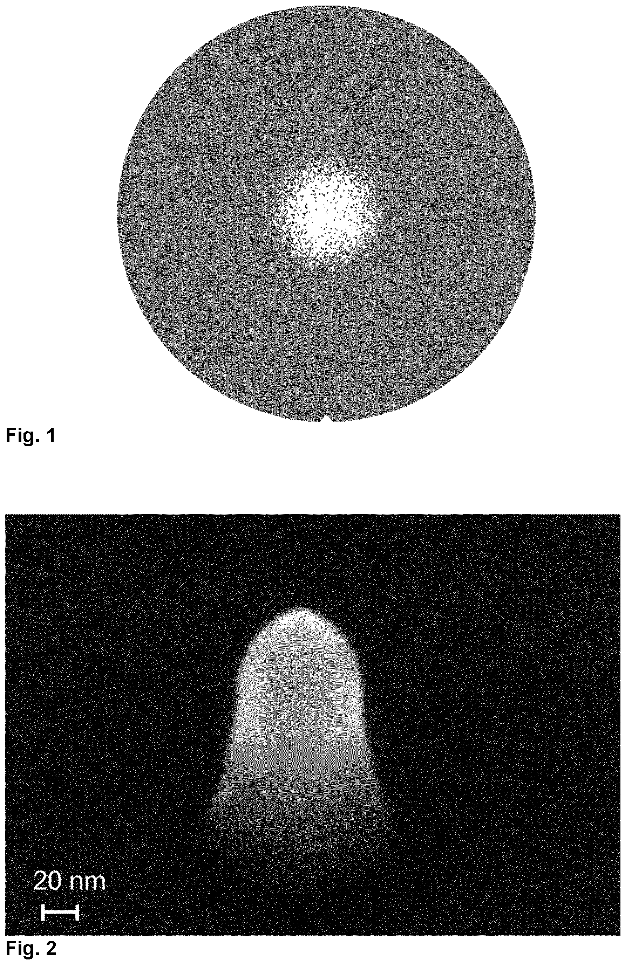

Instruments in einem Gasgemisch aus Sauerstoff, Bromwasserstoff, Chlor und Argon geätzt. Die Durchflussraten betrugen für Sauerstoff und Chlor jeweils 20 sccm, für Bromwasserstoff 30 sccm, und für Argon 100 sccm. Die Ätzzeit im Hauptschritt des RIE-Verfahrens betrug 5 min. Anschließend wurde die Vorderseite der geätzten Scheibe mittels Lichtstreumessung auf Defekte untersucht und so die Position und Größe von Oberflächendefekten auf der Scheibe identifiziert. Die Positionen sowie die Größen der Oberflächendefekte wurden wie oben beschrieben in einem elektronischen Format als KLARF-Datei festgehalten und gespeichert. Es konnte ein innerer, kreisförmiger Bereich mit einer hohen Defektdichte identifiziert werden (siehe Fig. 1). Der ringförmige, äußere Bereich der Oberfläche der Vorderseite zeigte sich weitgehend defektfrei. Die untersuchte Vorderseite der Scheibe wurde durch das reaktive Ionenätzen angeraut, was die Empfindlichkeit des Lichtstreusystems verringerte.

Anschließend wurde die KLARF-Datei auf einen mit einem Rasterelektronenmikroskop des Typs Sigma 300 des Herstellers Zeiss verbundenen Rechner übertragen. Mit dem Rasterelektronenmikroskop wurden Aufnahmen von Defekten an bestimmten Positionen aufgenommen (siehe Fig. 2). Der Konus eines typischen Defektes der Scheibe besitzt eine Höhe von ca. 260 nm. Die Höhe des Defekts ist also deutlich geringer als in den im Stand der Technik beschriebenen Prozessen. Die Konen wurden an ihrer Spitze während des reaktiven Ionenätzens nicht angegriffen, d.h. die Defekte wurden konserviert. Eine nachgeschaltete chemische Behandlung erfolgte nicht. Somit ist es möglich, die Defekte im Anschluss mit weiteren Analysemethoden wie der Transmissionselektronenmikroskopie zu untersuchen.

### Ausführungsbeispiel 2

Aus einer Scheibe aus einkristallinem Silizium wurden Segmente mittels einer kommerziell erhältlichen Spaltvorrichtung des Herstellers SELA hergestellt. Die Segmente können sowohl ausgehend von polierten und chemisch gereinigten Halbleiterscheiben, als auch aus ausgehend von aus einem Einkristallstab gesägten Scheiben, die keiner weiteren Behandlung unterzogen wurden, hergestellt werden. Ohne weitere Bearbeitung wurden die Segmente dem im Ausführungsbeispiel 1 beschrieben reaktiven Ionenätzprozess unterzogen, mit dem Unterschied, dass die Ätzzeit 10 Minuten betrug.

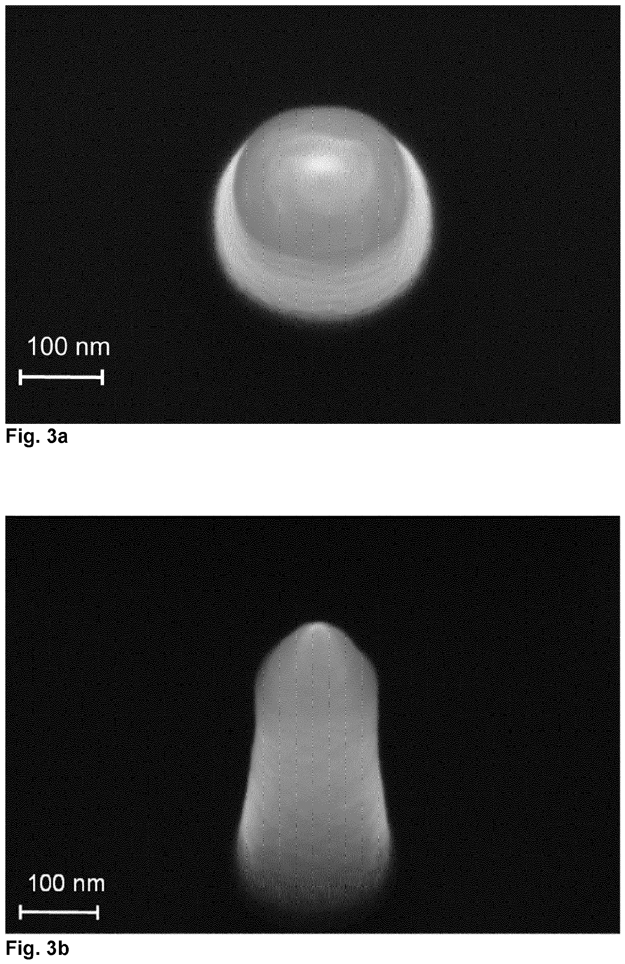

Danach wurde die Spaltkante des geätzten Segments mit einem Rasterelektronenmikroskop des Typs Sigma 300 des Herstellers Zeiss untersucht. Ein typischer Konus an der Spaltkante ist in Fig. 3a, und nach Verkippung im Rasterelektronenmikroskop in Fig. 3b gezeigt.

### Ausführungsbeispiel 3

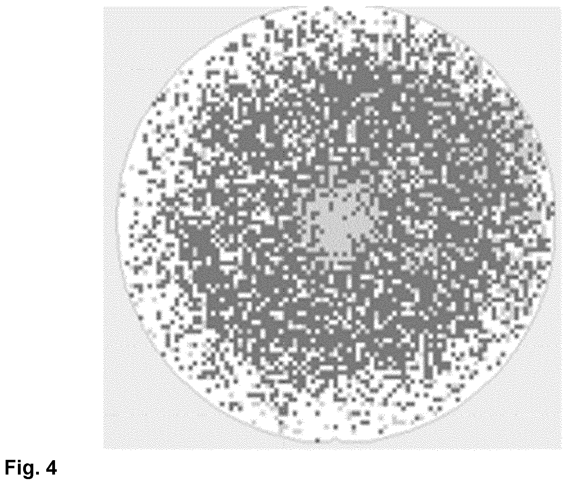

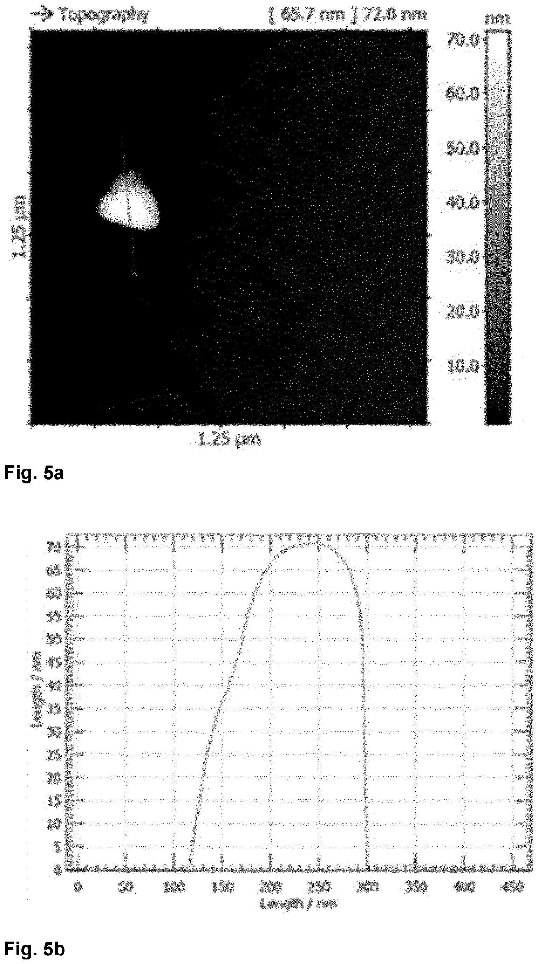

Eine polierte und chemisch gereinigte Scheibe aus einkristallinem Silizium wurde in einer RIE-Anlage wie im Ausführungsbeispiel 1 beschrieben geätzt. Das Ausführungsbeispiel 3 unterscheidet sich vom Ausführungsbeispiel 1 nur dadurch, dass die Ätzzeit auf 30 Sekunden verringert wurde. Anschließend wurde die Vorderseite der geätzten Scheibe mittels Lichtstreumessung auf Defekte untersucht und so die Position und Größe von Oberflächendefekten auf der Scheibe identifiziert. Die Positionen sowie die Größen der Oberflächendefekte wurden wie oben beschrieben in einem elektronischen Format als KLARF-Datei festgehalten und gespeichert. Im Gegensatz zum Ausführungsbeispiel 1 wurden auf der gesamten Vorderseite Defekte identifiziert, wie Fig. 4 zeigt. Es wurde ein innerer, kreisförmiger Bereich identifiziert, dessen Defektdichte mit der im Ausführungsbeispiel 1 identifizierten Defektdichte im inneren Bereich vergleichbar ist. Zusätzlich wurden aber auch im äußeren ringförmigen Bereich bis hin zum Scheibenrand Defekte identifiziert (siehe Fig.4). Dies zeigt, dass eine Ätzzeit von 30 Sekunden im Schritt (i) des erfindungsgemäßen Verfahrens ausreichend ist, um Defekte als Erhöhungen mit der für die anschließende Detektion im Schritt (ii) erforderlichen Höhe zu erzeugen. Gleichzeit wird durch die Verkürzung der Ätzzeit die Aufrauhung der Scheibenoberfläche verringert, so dass die Empfindlichkeit der Lichtstreumessung verbessert und die vorhandenen Defekte besser detektiert werden können. Eine mit einem Rasterkraftmikroskop gemachten Aufnahme eines typischen Defekts auf der in diesem Ausführungsbeispiel behandelten Scheibe ist in Fig. 5 a gezeigt. Fig. 5b zeigt das Höhenprofil dieses Defekts. Fig. 5a und 5 b zeigen, dass bereits eine Ätzzeit von 30 Sekunden im Schritt (i) des erfindungsgemäßen Verfahrens ausreicht, um Defekte als Erhöhungen mit einer Höhe von mehr als 20 nm sichtbar zu machen.

### Ausführungsbeispiel 4

Das Ausführungsbeispiel 4 unterscheidet sich vom Ausführungsbeispiel 3 nur dadurch, dass die Ätzzeit weiter von 30 Sekunden auf 15 Sekunden verringert wurde.

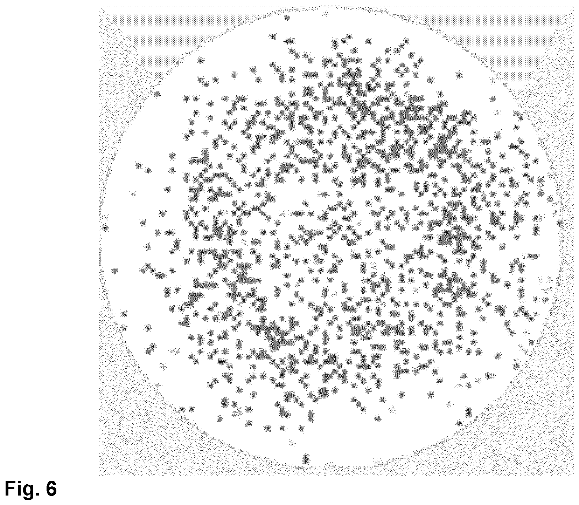

Bei der Oberflächeninspektion der Vorderseite der geätzten Scheibe mittels Lichtstreumessung wurden im Vergleich zum Ausführungsbeispiel 3 eine geringere Defektdichte auf der Vorderseite festgestellt (siehe Fig. 6). Dies zeigt, dass eine Verkürzung der Ätzzeit dazu führt, dass nicht mehr alle Defekte mittels Streulichtmessung detektiert werden können. Dies ist vermutlich auf eine unzureichende Ätzung der Defekt und einen damit verbundenen, geringeren Anteil der Defekte mit ausreichender Höhe zurückzuführen.

## Patentansprüche

1. Verfahren zur Bestimmung von Kristalldefekten in einem Werkstück aus einkristallinem Silizium, umfassend die folgenden Schritte
**(i)** Reaktives Ionenätzen mindestens einer Oberfläche des Werkstücks in einem Gasgemisch umfassend Sauerstoff und eine oder mehrere halogenhaltige Verbindungen ausgewählt aus der Gruppe bestehend aus elementaren Halogen X₂, Halogenwasserstoff HX und Stickstoffhalogenid NHₙX₃₋ₙ, wobei
X ausgewählt ist aus der Gruppe von Cl und Br, und 0 ≤ n ≤ 2,
die Flussrate von Sauerstoff und von jeder der ein oder mehreren halogenhaltigen Verbindung jeweils nicht weniger als 5 sccm und nicht mehr als 100 sccm beträgt, und
die mindestens eine, zu ätzende Oberfläche des Werkstücks dem Gasgemisch für nicht weniger als 10 Sekunden und nicht mehr als 20 Minuten ausgesetzt wird; und
**(ii)** Identifizieren von Defekten auf der geätzten Oberfläche des Werkstücks mittels Lichtstreumessung.

2. Verfahren zur Bestimmung von Kristalldefekten in einem Werkstück aus einkristallinem Silizium gemäß dem Anspruch 1, wobei das Gasgemisch Sauerstoff und eine oder mehrere halogenhaltige Verbindungen ausgewählt aus der Gruppe bestehend aus Chlor, Brom, Chlorwasserstoff und Bromwasserstoff umfasst.

3. Verfahren zur Bestimmung von Kristalldefekten in einem Werkstück aus einkristallinem Silizium gemäß dem Anspruch 1, wobei das Gasgemisch Sauerstoff und eine oder mehrere Verbindungen ausgewählt aus der Gruppe bestehend aus Chlor und Bromwasserstoff umfasst.

4. Verfahren zur Bestimmung von Kristalldefekten in einem Werkstück aus einkristallinem Silizium gemäß einem der Ansprüche 1 bis 3, wobei das Gasgemisch zusätzlich mindestens ein Inertgas ausgewählt aus der Gruppe aus Helium, Argon und Stickstoff umfasst.

5. Verfahren zur Bestimmung von Kristalldefekten in einem Werkstück aus einkristallinem Silizium gemäß dem Anspruch 1, wobei das Gasgemisch aus Sauerstoff, Chlor, Bromwasserstoff und Argon besteht.

6. Verfahren zur Bestimmung von Kristalldefekten in einem Werkstück aus einkristallinem Silizium gemäß einem der Ansprüche 1 bis 5, wobei die Flussrate von Sauerstoff und von jeder der ein oder mehreren halogenhaltigen Verbindungen jeweils nicht weniger als 10 sccm und nicht mehr als 50 sccm beträgt.

7. Verfahren zur Bestimmung von Kristalldefekten in einem Werkstück aus einkristallinem Silizium gemäß dem Anspruch 5, wobei
die Flussraten von Sauerstoff, Chlor und Bromwasserstoff jeweils nicht weniger als 10 sccm und nicht mehr als 50 sccm betragen, und
die Flussrate von Argon nicht weniger als 20 sccm und nicht mehr als 200 sccm beträgt.

8. Verfahren zur Bestimmung von Kristalldefekten in einem Werkstück aus einkristallinem Silizium gemäß einem der Ansprüche 1 bis 7, wobei die zu ätzende Oberfläche dem Fluss des Gasgemisches für nicht weniger als 20 Sekunden und nicht mehr als 10 Minuten ausgesetzt wird.

9. Verfahren zur Bestimmung von Kristalldefekten in einem Werkstück aus einkristallinem Silizium gemäß einem der Ansprüche 1 bis 8, wobei im Schritt (ii) die Positionen und Größen der identifizierten Defekte in einem elektronischen Format gespeichert werden.

10. Verfahren zur Bestimmung von Kristalldefekten in einem Werkstück aus einkristallinem Silizium gemäß einem der Ansprüche 1 bis 9, wobei zusätzlich ein Schritt (iii) durchgeführt wird, in welchem bestimmte, im Schritt (ii) identifizierte Defekte ausgewählt und mittels Elektronenmikroskopie und/oder Rasterkraftmikroskopie untersucht werden.

11. Verfahren zur Bestimmung von Kristalldefekten in einem Werkstück aus einkristallinem Silizium gemäß dem Anspruch 10, wobei im Schritt (iii) die Geometrie und/oder Morphologie der bestimmten, ausgewählten Defekte untersucht wird.

12. Verfahren zur Bestimmung von Kristalldefekten in einem Werkstück aus einkristallinem Silizium gemäß einem der Ansprüche 1 bis 11 wobei die zu ätzende Oberfläche dem Fluss des Gasgemisches für nicht weniger als 30 Sekunden und nicht mehr als 5 Minuten ausgesetzt wird.

13. Verfahren zur Bestimmung von Kristalldefekten in einem Werkstück aus einkristallinem Silizium gemäß einem der Ansprüche 1 bis 12, wobei im Schritt (i) ein Plasma durch ein hochfrequentes Magnetfeld erzeugt wird.

14. Verfahren zur Bestimmung von Kristalldefekten in einem Werkstück aus einkristallinem Silizium gemäß dem Anspruch 13, wobei das hochfrequente Magnetfeld eine magnetische Flussdichte von nicht weniger als 0.5 mT und nicht mehr als 20 mT aufweist.

15. Verfahren zur Bestimmung von Kristalldefekten in einem Werkstück aus einkristallinem Silizium gemäß einem der Ansprüche 1 bis 14, wobei im Schritt (i) ein Druck von nicht weniger als 0,5 und nicht mehr als 20 Pa herrscht.

16. Verfahren zur Bestimmung von Kristalldefekten in einem Werkstück aus einkristallinem Silizium gemäß einem der Ansprüche 1 bis 15, wobei im Schritt (i) die Zeit, für die die mindestens eine, zu ätzende Oberfläche des Werkstücks dem Gasgemisch ausgesetzt wird, so eingestellt wird, dass das durch das Ätzen erzeugte Profil auf der Oberfläche des Werkstücks eine Tiefe von nicht mehr als 1000 nm, vorzugsweise von nicht mehr als 500 nm, aufweist.

17. Verfahren zur Herstellung von Scheiben aus einkristallinem Silizium, umfassend die folgenden Schritte:
Ziehen eines Einkristallstabs aus einkristallinem Silizium gemäß dem Czochralski-Verfahren;
Schleifen des Einkristallstabs;
Sägen des geschliffenen Einkristallstabs in Scheiben;
Schleifen und/oder Läppen der Scheiben;
chemisches Ätzen der Scheiben;
Polieren der Scheiben; und
chemisches Reinigen der Scheiben,
**dadurch gekennzeichnet, dass** das Verfahren gemäß einem der Ansprüche 1 bis 16 stichprobenartig im Rahmen der Prozesskontrolle durchgeführt wird.
